(19) **Europäisches Patentamt / European Patent Office / Office européen des brevets**

(11) **EP 4 508 453 B1**

(12) **FASCICULE DE BREVET EUROPEEN**

(45) Date de publication et mention de la délivrance du brevet:
**29.04.2026 Bulletin 2026/18**

(21) Numéro de dépôt: **23716251.6**

(22) Date de dépôt: **29.03.2023**

(51) Classification Internationale des Brevets (IPC):
**G01R 33/24** *(2006.01)*     **G01R 33/34** *(2006.01)*
**G01R 33/32** *(2006.01)*     **G01R 33/565** *(2006.01)*

(52) Classification Coopérative des Brevets (CPC):
**G01R 33/326; G01R 33/24; G01R 33/34015; G01R 33/34046; G01R 33/5659**

(86) Numéro de dépôt international:
**PCT/EP2023/058210**

(87) Numéro de publication internationale:
**WO 2023/198459 (19.10.2023 Gazette 2023/42)**

(54) **CONCENTRATEUR DE FLUX GRADIOMETRIQUE DE VOLUME POUR DETECTION MAGNETIQUE ULTRASENSIBLE ET SYSTEME DE DETECTION MAGNETIQUE A BASE DE SQUID METTANT EN OEUVRE CE CONCENTRATEUR DE FLUX**

RADIOMETRISCHER VOLUMENFLUSSKONZENTRATOR FÜR ULTRAEMPFINDLICHE MAGNETISCHE DETEKTION UND SQUID-BASIERTES MAGNETISCHES DETEKTIONSSYSTEM MIT DIESEM FLUSSKONZENTRATOR

GRADIOMETRIC VOLUMETRIC FLUX CONCENTRATOR FOR ULTRASENSITIVE MAGNETIC DETECTION AND SQUID-BASED MAGNETIC DETECTION SYSTEM USING THIS FLUX CONCENTRATOR

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **12.04.2022 FR 2203365**

(43) Date de publication de la demande:
**19.02.2025 Bulletin 2025/08**

(73) Titulaire: **Chipiron**
**75169 Paris Cedex 19 (FR)**

(72) Inventeurs:
- **LABAT, Dimitri**
  **75169 Paris Cedex 19 (FR)**
- **COUVREUR, Romain**
  **75169 Paris Cedex 19 (FR)**

(74) Mandataire: **IP Trust**
**2, rue de Clichy**
**75009 Paris (FR)**

(56) Documents cités:
**WO-A2-2009/023303**

- **MORELLO A ET AL: "Automated and versatile SQUID magnetometer for the measurement of materials properties at millikelvin temperatures", REVIEW OF SCIENTIFIC INSTRUMENTS, AMERICAN INSTITUTE OF PHYSICS, 2 HUNTINGTON QUADRANGLE, MELVILLE, NY 11747, vol. 76, no. 2, 5 January 2005 (2005-01-05), pages 23902 - 023902, XP012079184, ISSN: 0034-6748, DOI: 10.1063/1.1841831**

**Description**

**DOMAINE DE L'INVENTION**

La présente invention concerne une antenne primaire destinée à être utilisée comme concentrateur de flux pour un magnétomètre ultrasensible. Cette antenne est un gradiomètre de géométrie volumique en cuivre. L'invention vise également des équipements intégrant cette antenne : dispositif de détection magnétique à SQUID, ou tous autres types de magnétomètres ultra-sensibles (centres NV, capteurs à magnétoré-sistance géante, magnétomètres atomiques), IRM basée sur une détection à SQUID, biomagnétisme, ou plus généralement magnétométrie ultrasensible en champ proche.

**ETAT DE LA TECHNIQUE**

Le SQUID (« Superconducting Quantum Interference Device » pour dispositif d'interférence quantique supraconducteur) est un magnétomètre de taille micrométrique, constitué d'une boucle en matériau supraconducteur interceptée par deux Jonctions Josephson. Les technologies et matériaux utilisés sont très variables, mais on distingue deux grandes familles : les SQUID à basse température critique (bas Tc), fonctionnant sous les 10 K, présentant des performances supérieures mais nécessitant une cryogénie plus lourde, et les SQUID haute température critique, de performances moindres et de fabrication plus complexe, mais pouvant fonctionner à la température de l'azote liquide (77 K). Le SQUID se comporte comme un flux-mètre, c'est-à-dire qu'il produit une tension V ($\Phi$) sinusoïdale dépendant du flux magnétique $\Phi$ le traversant. Ce sont des magnétomètres présentant de très hautes performances : parmi leurs nombreux avantages, on trouve en premier lieu leur extrême sensibilité (seuil de détection approchant les 1 fT.Hz $^{-1/2}$) [1], leur large bande d'utilisation, jusqu'à plus de 100 MHz [2], et la conservation de leur sensibilité jusqu'aux très basses fréquences, y compris en champ continu (DC). Une description détaillée du fonctionnement des SQUID est donnée dans le livre de John Clarke [3].

En raison de leur petite taille, les SQUID sont beaucoup utilisés en champ proche, c'est-à-dire pour mesurer le magnétisme local aux petites échelles, par exemple pour cartographier les domaines magnétiques de certains matériaux. L'utilisation de SQUID en champ plus lointain, en particulier pour des expériences d'IRM ou de mesure du biomagnétisme, requiert en général l'utilisation d'un concentrateur de flux. Il s'agit d'une antenne magnétique classique en série avec une bobine d'entrée placée au-dessus du SQUID. Le flux magnétique est capté par l'antenne primaire, puis retransmis au niveau du SQUID via la bobine d'entrée. En somme, on peut comprendre l'utilisation du concentrateur de flux comme si la surface du SQUID était virtuellement augmentée, lui permettant de capter un large flux magnétique malgré sa petite taille. Ces concentrateurs de flux peuvent être de géométries diverses, fabriqués à partir de métaux comme le cuivre ou de matériaux supraconducteurs comme des fils de Niobium-Titane. Un état des lieux des diverses implémentations des concentrateurs de flux est donné dans la revue de Fagaly [4] ou de manière plus détaillée dans le chapitre du livre de Weinstock [5].

Jusqu'à présent, le point commun des implémentations de concentrateurs de flux est d'utiliser des antennes primaires de surface, le plus souvent gradiométriques. Supposons que le signal magnétique à mesurer est émis de manière isotrope dans l'espace par une source S. Une antenne de surface n'intercepte qu'une fraction du signal émis par la source, tandis qu'une antenne de volume a pour rôle d'englober la source S afin de recueillir le maximum de signal. Jusqu'à présent, dans le cadre de la détection magnétique à SQUID a basse température critique, les antennes de surface ont toujours été préférées. En effet, on cherche à avoir une antenne de résistance électrique la plus basse possible afin de minimiser le bruit de Johnson-Nyquist. Les concentrateurs de flux sont donc le plus souvent fabriqués en matériau supraconducteur, par exemple en fil de Niobium-Titane, et doivent donc être refroidis à 4K. Pour cette raison, l'antenne primaire doit être confinée au fond d'un cryostat, ce qui impose l'utilisation d'une antenne de surface.

Dans le cas des SQUIDs à haute température critique, il n'est pas possible d'utiliser des antennes filaires supraconductrices comme pour le bas Tc, car les matériaux utilisés sont des céramiques qui se prêtent mal à la fabrication de fils. Les technologies les plus répandues sont des antennes planaires supraconductrices, même si certaines expériences ont fait usage d'antennes volumiques en cuivre couplées au SQUID.

Le SQUID couplé à une antenne primaire étant un dispositif très sensible, il est également très vulnérable face au bruit électromagnétique ambiant. Pour s'en prémunir, on peut configurer l'antenne primaire comme un gradiomètre. Prenons le cas simple d'un gradiomètre axial d'ordre 1. Dans ce cas, l'antenne est constituée de deux boucles de même axe tournant en des sens opposés, séparées d'une distance $b$. Ce dispositif est moins sensible au signal d'intérêt qu'une simple boucle, car la deuxième boucle tournant en sens opposé aura tendance à compenser le signal reçu par la première boucle. En revanche, ce système aura tendance à rejeter le bruit provenant de sources situées à une distance $R \gg b$.

En effet, du point de vue de la source du bruit, les deux boucles du gradiomètre se situent à la même distance, et donc le signal reçu par le gradiomètre de la part de la source de bruit se compense entre les deux boucles. En réalité, le système ainsi décrit se nomme gradiomètre car il est sensible au gradient du champ magnétique, plut6t qu'au champ magnétique lui-même. Il existe de nombreux autres systèmes de gra-diométrie de géométrie plus complexe, sensibles aux dérivées d'ordre supérieur du champ magnétique.

Plus l'ordre du gradiomètre est élevé, plus la propriété de réjection du bruit est efficace, mais moins le système sera sensible au signal d'intérêt : il y a donc un compromis à trouver. D'une manière générale, on retiendra que si le champ émis par une source décroît comme $R^{-3}$ avec la distance $R$ à la source, le gradient décroît comme $R^{-4}$, et la dérivée d'ordre $k$ du champ décroît comme $R^{-3-k}$. On trouvera une description détaillée des différentes implémentations de gradiomètres de surface dans la revue de Fagaly précédemment citée.

Il existe diverses implémentations de systèmes de SQUID avec concentrateur de flux. Ci-dessous sont listées quelques antériorités classées par type de technologie.

Pour les gradiomètres bas Tc, on se référera utilement aux documents cités [6] à [11].

Pour les gradiomètres haut Tc, on se référera utilement aux documents cités [12] à [18].

Pour autant, ces concentrateurs de flux ne résolvent pas le problème du manque de sensibilité des systèmes de détection à SQUID actuels. Le but de l'invention est de proposer un nouveau concentrateur de flux qui, combiné à un détecteur à SQUID, permet de réaliser un magnétomètre présentant une sensibilité nettement supérieure à celle des magnétomètres actuels, tout en robuste face au bruit électromagnétique ambiant.

## REFERENCES

1. Stolz et al., Supercond. Sci. Technol. 12, 806-808 (1999).

2. D. Drung et al., dc SQUID readout electronics with up to 100 MHz clo8ed-loop bandwidth, in IEEE Tran8action8 on Applied Superconductivity, vol. 15, no. 2, pp. 777-780, June 2005

3. J. Clarke and A.I. Bragin8ki, The SQUID handbook vol. 1, Wiley-VCH.

4. Fagaly et al., Review of Scientific Instruments 77, 101101 (2006).

5. SQUID sensors : Fundamentals, Fabrication and Applications, NATO ASI Series, Springer Science, 1995, pages 117 - 178.

6. Seton 1999. Seton et al. Magnetic resonance materials in physics, biology and medicine 8 116-120 (1999). Gradiomètre planaire ou axial bas Tc pour l'IRM bas champ.

7. Stolz 1999. Stolz et al., Supercond. Sci. Technol. 12, 806-808 (1999). Gradiomètres bas Tc de géométrie planaire.

8. Stolz 2001. IEEE Transactions on applied superconductivity 11, vol. 1 (2001). Gradiomètre d'ordre deux planaire bas Tc.

9. JP2010148578A. Gradiomètres axiaux pour la magnétoencéphalographie.

10. US2013271142A1. Système d'IRM à SQUID comprenant plusieurs gradiomètres d'ordre deux bas Tc.

11. WO2006052236A1. Système d'IRM à SQUID bas Tc comprenant un gradiomètre d'ordre deux non accordé.

12. Tavrin 1994. Tavrin et al., Supercond. Sci. Technol. 7 265-268 (1994). Gradiomètre d'ordre deux axial pouvant opérer sans blindage pour la magnétocardiographie.

13. Oisjoen 2008. Oisjoen et al. Supercond. Sci. Technol 21, 034004 (2008). Gradiomètre haut Tc pour des expériences d'immunoessais magnétiques.

14. Schmidt 2004. Schmidt et al. Exploration Geophysics 35 297-305 (2004). Gradiomètre à SQUID haut-Tc triaxial permettant d'avoir les trois composantes du champ magnétique.

15. Schultze 2001. Schultze et al., Supercond. Sci. Technol 15 120-125 (2002). Gradiomètre planaire pour utilisation sans blindage.

16. DE19509230A1. Gradiomètre haut Tc pour la détection de champs bioma-gnétiques.

17. CN106814338. Système de réduction de bruit basé sur un gradiomètre d'ordre 1 pour application en résonance magnétique nucléaire, détection faite avec un gradiomètre d'ordre2.

18. CN107430174A. Système assurant la stabilité thermique d'un gradiomètre axial à SQUID.

19. Nardelli 2020. Nardelli et al. EPJ Quantum Technology 7 :11 (2020). Implémentation d'un gradiomètre axial pour de la magnétoencéphalographie. La détection magnétique se fait dans ce cas avec des magnétomètres atomiques. Dans ce cas précis (pas de SQUID) le gradiomètre est constitué de deux magnétomètres atomiques, sans concentrateur de flux.

20. Chen 2011. Chen et al. Journal of applied physics 110 093903 (2011). IRM bas champ détectée par un système à SQUID haut-Tc comprenant une antenne primaire volumique (solénoïde) non gradiométrique.

21. Hout et al. J. of Mag. Res. 24 vol. 1, 71-85 (1976).

22. AIP Advances 8, 075126 (2018).

23. WO 2009/023303 A2 (Penanen et al.)

**Exposé de l'invention**

L'invention propose de répondre au problème de manque de sensibilité des systèmes de détection à SQUID actuels grâce à une antenne gradiométrique de volume en cuivre, permettant de recueillir plus de signal tout en gardant une robustesse face au bruit, telle que définie par la revendication 1.

Cet objectif est atteint avec un dispositif concentrateur de flux disposé en amont d'un magnétomètre *ultrasensible,* prévu pour recevoir en entrée un flux magnétique externe et délivrer un flux concentré en entrée dudit magnétomètre, caractérisé en ce qu'il comprend une antenne primaire de détection magnétique volumique gradiométrique refroidie à une température cryogénique et un transformateur de flux disposé entre l'antenne primaire de détection et le magnétomètre, ledit transformateur de flux ayant un enroulement primaire relié à ladite antenne primaire de détection.

Dans une configuration particulière de l'invention, l'antenne primaire comprend deux antennes en série respectivement interne et externe, présentant une même inductance et agencées de sorte que le courant parcourant l'antenne externe est de sens opposé à celui parcourant l'antenne interne.

Dans une configuration particulière de l'invention, l'antenne primaire comprend deux antennes en série respectivement interne et externe, présentant une même surface orientée totale et agencées de sorte que le courant parcourant l'antenne externe est de sens opposé à celui parcourant l'antenne interne.

L'antenne interne peut être disposée à l'intérieur de l'antenne externe et présente une longueur et un diamètre respectivement inférieurs à la longueur et à au diamètre respectifs de l'antenne externe.

Les antennes respectivement interne et externe peuvent être réalisées à partir de fils conducteurs respectivement interne et externe, le fil conducteur interne présentant une section inférieure à la section du fil conducteur externe.

Dans d'autres configurations de l'invention, l'antenne primaire de détection comprend en outre au moins une antenne intermédiaire disposée en série entre l'antenne externe et l'antenne interne.

Le dispositif concentrateur de flux peut en outre comprendre en outre des moyens pour blinder électromagnétiquement l'antenne primaire de détection.

Ces moyens de blindage électromagnétique peuvent être de type passif ou actif, mettant alors en œuvre au moins une bobine de compensation de bruit extérieur.

L'antenne primaire de détection peut être refroidie par des moyens pour refroidir l'antenne primaire de détection par circulation d'un liquide cryogénique tel que de l'azote liquide, ou bien l'antenne primaire de détection peut être disposée dans un cryostat comportant un tube pulsé et un circuit d'hélium gazeux.

Suivant d'autres aspects de l'invention, il est proposé un équipement de résonance magnétique nucléaire, un équipement d'imagerie par résonance magnétique, un équipement de détection magnétique mis en œuvre dans des applications de biomagnétisme, dont le système de détection intègre un dispositif concentrateur de flux selon l'invention.

On peut aussi prévoir un équipement pour mesurer des variations très faibles de champ magnétique statique ou bien un équipement de détection magnétique large bande, ou encore un équipement de détection magnétique ou de résonance magnétique nucléaire utilisé pour le contrôle qualité dans l'industrie agroalimentaire, dont le système de détection intègre un dispositif concentrateur de flux selon l'invention.

Suivant encore un autre aspect de l'invention, il est proposé un système de détection et d'acquisition radiofréquence (RF) à base de SQUID, prévu notamment pour être intégré dans un appareil à résonance magnétique nucléaire (IRM ou RMN), comprenant :

- un dispositif concentrateur de flux selon l'invention,
- un dispositif SQUID, agencé pour être soumis au flux issu dudit dispositif concentrateur de flux, et délivrer un signal de détection secondaire,
- un dispositif de cryogénie prévu pour refroidir le dispositif SQUID,
- un étage de traitement du signal de détection secondaire émis par le dispositif SQUID, pour délivrer un signal analogique d'acquisition, comprenant une boucle à verrouillage de flux (FLL) prévue pour linéariser la réponse du dispositif SQUID.

Le dispositif concentrateur de flux mis en œuvre dans ce système peut avantageusement comporter une zone interne prévue à l'antenne de détection primaire pour recevoir une partie du corps d'un sujet humain ou animal.

**DESCRIPTION DES FIGURES**

- [Fig.1] La [Fig.1] présente différentes géométries d'antennes volumiques envisagées dans le cadre de la présente invention ;
- [Fig.2] La [Fig.2] présente, sur l'exemple de la géométrie selle de cheval, les différents ordres de gradiomètre qu'il est possible d'implémenter ;

- [Fig.3] La [Fig.3] présente une implémentation possible de l'antenne dans le cadre d'une expérience de détection magnétique à SQUID pour l'IRM.

**DESCRIPTION DETAILLEE**

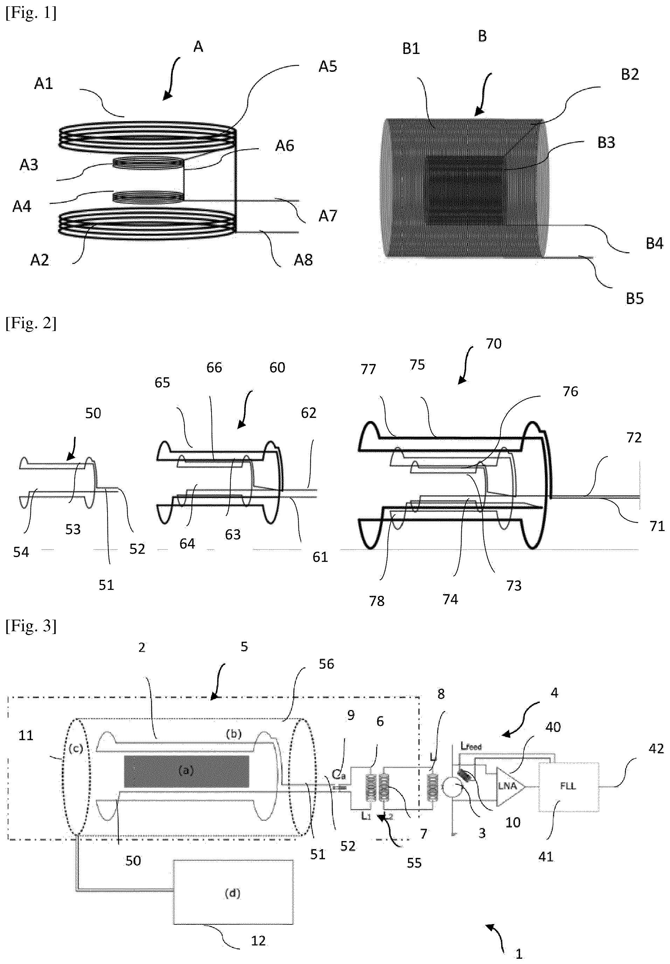

Toutes les géométries représentées en [Fig.1] ont le point commun d'être gradiométriques, et de volume. On peut considérer une géométrie de type « selle de cheval », Helmholtz, solénoïde, ou tout autre type de géométrie volumique. Il est possible d'envisager des gradiomètres d'ordre supérieur pour ces géométries, comme décrit en [Fig.2]. Dans la géométrie solénoïde comme Helmholtz, le courant se déplace en sens opposé entre la partie interne et la partie externe de l'antenne.

Les dimensions exactes des géométries représentées en [Fig.2] ne sont pas respectées pour que les figures soient plus lisibles. Le câblage de l'antenne est fait de sorte à alterner le sens du courant d'un étage à l'autre.

L'antenne de détection primaire mise en œuvre dans un concentrateur de flux selon l'invention présente une structure gradiométrique qui peut être de différents ordres, comme l'illustrent les trois géométries d'ordre respectivement 0,1 et 2 représentées en [Fig.2].

La première géométrie 50 est du type selle de cheval, bien connue de l'homme du métier pour ses performances notamment en termes d'homogénéité spatiale. Le diamètre de l'antenne selle de cheval est par exemple égal à 1,5 fois sa longueur. L'antenne volumique gradiométrique 50 d'ordre 0 comporte une bobine 53,54 présentent deux bornes de connexion 51,52.

Dans la seconde géométrie 60, l'antenne de détection primaire d'ordre 1 comporte une antenne externe en forme de selle de cheval 65,66 en série avec une antenne interne en forme de selle de cheval 63,64 incluse dans l'antenne externe, et deux bornes de connexion 61,62.

L'antenne de détection primaire volumique gradiométrique 70 d'ordre 2 comporte une antenne externe en forme de selle de cheval 77,78 contenant une antenne intermédiaire 75,76 dans laquelle est insérée une antenne interne 73,74. Les antennes respectivement externe, intermédiaire et interne sont reliées en série de sorte que l'antenne de détection primaire 70 présente deux bornes de connexion 71,72.

Les antennes externe, interne ou intermédiaire dans ces différentes configurations présentent par exemple un seul tour de fil.

L'autre géométrie (b) est la version gradiométrique d'ordre 1 de la selle de cheval. Cette antenne volumique 5' est constituée de deux sous-antennes 51,52 montées en série l'une de l'autre. La première antenne 51, interne, est de géométrie selle de cheval et présente dans cet exemple deux tours de fil.

Les dimensions du système et l'orientation des fils des antennes sont choisies de telle sorte que la partie externe et la partie interne de l'antenne ont la même surface totale orientée, et que le courant dans la partie interne circule en sens opposé du courant dans la partie externe.

Avec cette configuration, une antenne gradiométrique-selle de cheval permet de rejeter le bruit provenant de sources se situant à une distance grande devant les dimensions de l'antenne, tout en bénéficiant des propriétés d'homogénéité de la géométrie selle de cheval. Une description détaillée du principe des antennes gradiométriques se trouve dans l'article de R. L. Fagaly [4].

L'antenne présentée dans l'exemple de la [Fig.3] illustrant un système 1 de détection pour IRM à base de SQUID est un gradiomètre d'ordre 0 (ou magnétomètre) comportant une antenne primaire de détection 50 ayant une géométrie selle de cheval et intégrée dans un cryostat 56, mais tout autre antenne volumique peut être utilisée. L'échantillon (a) 2 dont on veut faire une image IRM est placé au cœur de l'antenne primaire (b) 50, ici de géométrie selle de cheval. L'échantillon peut par exemple être un genou humain que l'on enfile à l'intérieur de l'antenne primaire 50. La partie (c) 11 en pointillés représente un ensemble (non présenté) de bobines de polarisation et de gradients nécessaires pour accomplir l'expérience d'IRM. Ces bobines sont commandées par une console (d) 12. Le signal de l'antenne primaire 50 est transmis vers le SQUID 3 via un transformateur de flux ( $L_1$, $L_2$) 6,7 ; 55 servant à faire l'adaptation d'impédance entre l'antenne primaire 50 et la bobine d'entrée 8 du SQUID $L_i$.

Comme il s'agit d'une antenne résonante, dans le cas où l'antenne est résonante, un condensateur 9 de couplage de capacitance $C_a$ est relié en parallèle à l'enroulement primaire 6 du transformateur de flux 55.

Le signal en sortie du SQUID 3 sur la bobine de sortie $L_{feed}$ 10 est ensuite amplifié via un préamplificateur (LNA) 40, et la stabilité du point de fonctionnement est assurée par une boucle de contre réaction (FLL) 41 . Le signal amplifié 42 passe ensuite par un étage de conversion analogique-numérique (non représenté).

**Exemple de calcul de la géométrie de l'antenne**

On considère d'abord pour exemple le cas d'une antenne de forme selle de cheval. Cette antenne est de géométrie cylindrique, et sa longueur $a$ est reliée au diamètre $D$ par $a = \underline{3} D$. Dans cet exemple, on doit garder au cœur de l'antenne un espace de diamètre minimal 18 cm afin de pouvoir accueillir un genou. En comptant une marge de 6*cm* pour tenir compte de l'épaisseur de l'antenne ainsi que de l'enceinte du cryostat assurant son refroidissement, on prendra un diamètre *D* = 24 cm et donc une longueur *a* = 36 cm.

On considère maintenant la section du conducteur de l'antenne. On utilise ici comme conducteur le cuivre, qui permet de mettre en œuvre une cryogénie plus simple que pour les antennes supraconductrices. On cherche à avoir une antenne de résistance la plus basse possible, afin de minimiser le bruit de Johnson-Nyquist, donc un conducteur de section la plus grande possible.

Cependant, en raison de l'épaisseur de peau (notée $\delta$), il n'est pas pertinent de considérer des diamètres de conducteur supérieurs à $2\delta$. Aux fréquences de travail nous intéressant, entre 10 kHz et 100 kHz, l'épaisseur de peau du Cuivre varie entre 600 $\mu$m et 200 $\mu$m. En prenant pour référence la valeur $\delta$ = 500 $\mu$m, on a donc un diamètre maximal pour notre antenne *d* = 1 mm.

Pour construire un gradiomètre de volume, l'idée est de mettre en série deux antennes de surfaces totales orientées S$_1$ et S$_2$opposées pour un champ magnétique quasi-uniforme.

$$\vec{S_j} = \iint\limits_{\text{Antenne } j} \vec{dS}$$

Le courant parcourant l'antenne externe est de sens opposé a celui parcourant l'antenne interne. Ainsi ce système, représenté à la [Fig.1], fonctionne comme un gradiomètre d'ordre 1 en ce qu'il rejette le bruit provenant de source distantes par compensation entre l'antenne interne et l'antenne externe.

Pour construire un gradiomètre volumique d'ordre deux, on respecte le même principe que pour les gradiomètres surfaciques décrits dans le livre de Weinstock [5]. On met en série trois antennes, l'antenne interne et l'antenne externe ont la même surface totale orientée tandis que l'antenne intermédiaire a une surface totale orientée qui est le double et de direction opposée. Cette dernière contrainte étant obtenue en faisant circuler les courants en des sens opposés d'un étage à l'autre.

$$\vec{S_j} = \iint\limits_{Antenna\ j} \vec{dS}, \qquad \vec{S_2} = -2\vec{S_1} = -2\vec{S_3}$$

Pour les ordres supérieurs de gradients, on continue de suivre le même principe de construction : les rapports entre les surfaces totales de chaque étage et le sens de circulation du courant sont donnés par les coefficients et le signe du développement discret de la dérivée n-ième. Par exemple pour l'ordre deux, on a

$$\frac{\partial^2 B(x)}{\partial x^2} \simeq \frac{1}{\epsilon^2}\left(B(x+\epsilon) - 2B(x) + B(x-\epsilon)\right) \qquad (1)$$

pour une distance *1* petite devant la position x.

Considérons l'antenne interne. On cherche à calculer la surface orientée effective d'une antenne de géométrie selle de cheval, de longueur $a_{int}$ = 36, 0 cm et de diamètre $D_{int}$ = 24, 0 cm.

On pourra se référer à la [Fig.1] pour plus de clarté. Une telle antenne a pour surface orientée totale $S_{int}$ = 0,150 m$^2$, orientée selon l'axe qui passe par les centres des deux panneaux de l'antenne. En prenant maintenant une antenne externe avec le même angle et de diamètre $D_{ext}$ = 30, 0 cm, on doit avoir, en respectant l'égalité des surfaces totales, la longueur $a_{ext}$ = 28,8 cm. Une alternative est de doubler l'antenne interne en enroulant le fil une deuxième fois. Dans ce cas la surface effective de l'antenne interne est $S_{int}$ = 0,299 m$^2$ et il est possible de respecter la contrainte $a_{ext}$ = 3/2 $D_{ext}$ en prenant $D_{ext}$ = 34cm et $a_{ext}$ = 51cm.

L'inductance totale de l'antenne dans le premier cas est estimée à *L* = 4, 7 $\mu$H. On sait que pour avoir le maximum de sensibilité du dispositif SQUID + antenne, l'inductance de l'antenne primaire doit être égale à l'inductance de la bobine d'entrée du SQUID.

Ce fait est décrit dans la publication FR2012642. Cette condition peut être satisfaite à un facteur 2 près, n'impactant que très peu la sensibilité, avec le dispositif commercial SQ2600 de STAR Cryoelectronics présentant une inductance d'entrée $L_i$ = 2580 nH.

**Bruit de Johnson-Nyquist dans l'antenne primaire**

Utiliser un détecteur aussi sensible que le SQUID n'est pas sans inconvénient : son extrême sensibilité le rend très vulnérable aux perturbations extérieures. Le bruit capté par le système antenne primaire + SQUID a essentiellement deux origines :

- Le bruit provenant de sources extérieures au dispositif. L'essentiel de la densité spectrale de bruit se trouve dans la bande allant du DC à quelques kHz. On notera particulièrement la contribution au bruit de la microphonie engendrée par les vibrations mécaniques du tube pulsé utilisé pour la cryogénie.
- Le bruit interne au dispositif. Il s'agit essentiellement de bruit de Johnson-Nyquist, typiquement d'amplitude bien moindre que le bruit extérieur. Cependant, pour tirer un avantage maximal des performances du SQUID, on va chercher à minimiser le bruit en flux provoqué par la bobine d'entrée pour le maintenir inférieur au bruit en flux intrinsèque du SQUID. Le bruit en $1/f$ est négligeable aux fréquences auxquelles nous travaillons (entre 10 et 100 kHz).

Comme mentionné précédemment, dans la plupart des implémentations déjà réalisées, l'antenne primaire est supraconductrice afin de limiter le bruit de Johnson. Cependant, utiliser une antenne supraconductrice n'est pas sans inconvénients

- L' application selon l'invention requiert que l'antenne soit placée dans un cryostat léger qui englobe l'échantillon. Ce cryostat ne peut être refroidi aux températures requises pour utiliser des antennes en Niobium devant être thermalisées à 4K.
- Une solution serait d'utiliser des matériaux haut Tc pour l'antenne, tels YBCO. De tels matériaux sont des céramiques et il n'est pas possible de fabriquer simplement une antenne filaire avec. De plus, la structure cristalline en couches rend la fabrication de dispositifs autres que planaires très difficile, si ce n'est impossible.

Pour ces raisons, on privilégie la configuration d'une antenne en Cuivre, de préférence en Cuivre OFHC afin de réduire encore plus la résistivité. On suppose que l'on a pu refroidir cette antenne a une température $T$ = 40 K. A cette température, un cuivre de qualité moyenne a une résistivité d'environ $\varrho \approx 6.10^{-10}$ $\Omega$.m. En considérant l'antenne selle de cheval gradiométrique de volume décrite en partie précédente, on a une longueur de fil de 245 cm pour la partie interne, pour un diamètre de fil de 0, 7 mm, et une longueur de 259 cm pour la partie externe, pour un diamètre de fil de 1,0 mm. Cette antenne a une résistance totale d'environ

$$R \simeq 1,5\,\mathrm{m\Omega} \qquad (2)$$

La valeur RMS du bruit de Johnson Nyquist associé à cette antenne est donnée par

$$V_n = (4Rk_BT)^{1/2} \qquad (3)$$

où T est la température et $k_B$ la constante de Boltzmann. Pour $T$ = 40 K, on obtient

$$V_n \simeq 1,8.10^{-12}\,\mathrm{V}/\sqrt{\mathrm{Hz}} \qquad (4)$$

On souhaite mesurer l'impact de ce bruit en tension sur le signal capté par le SQUID. Pour cela, commençons par remarquer que l'impédance totale $Z$ de l'antenne à la fréquence d'intérêt $\omega$ est simplement $Z = L\omega$ puisqu'à la fréquence d'intérêt, $f_0 \approx 42$ kH', on a $R \ll L\omega$.

L'antenne gradiométrique a pour inductance $L \approx 5\,5\ \mu$H. Le bruit en courant dans l'antenne est alors simplement

$$I_n = \frac{V_n}{2\pi L f_0} \simeq 1,25\,\mathrm{pA}/\sqrt{\mathrm{Hz}} \qquad (5)$$

Ce bruit en courant, présent dans la bobine d'entrée du SQUID, produit un bruit en flux via le couplage entre le SQUID et sa bobine d'entrée. On utilise comme exemple le modèle SQ2600 de STAR Cryoelectronics, présentant un couplage entre le SQUID et la bobine d'entrée $M_i$ = 10 $\Phi_0/\mu$A. Le bruit en flux provoque au niveau du SQUID par l'antenne primaire est donc

$$\Phi_n^{(\mathrm{sq})} = M_i I_n = 12,5 \ \mu\Phi_0/\sqrt{\mathrm{Hz}} \qquad (6)$$

ce qui est à comparer au bruit intrinsèque du SQUID, donc pour ce modèle inférieur à 5 $\mu\Phi_0/$ Hz.

Le bruit calculé est donc du même ordre de grandeur, ce qui laisse une possibilité d'optimiser le système en passant sous le seuil de bruit du SQUID, notamment en choisissant un Cuivre de meilleure qualité.

### Température

Si on se réfère à la figure de S. Calatroni, arXiv 2006.02842vl, suivant la pureté, la résistivité du Cuivre à 40 K varie de $2.10^{-10}$ à $1,5.10^{-9}$ $\Omega$.m. Cette température peut être atteinte grâce à un système de cryogénie utilisant un tube pulsé couplé à une circulation d'Hélium gazeux, par exemple le modèle RP-082B2S de Sumitomo.

Il est cependant beaucoup plus simple d'utiliser un refroidissement à l'Azote liquide dans un premier temps. A 77 K, la résistivité du Cuivre varie de $1.10^{-9}$ à $2,5.10^{-9}$ $\Omega$.m. On pourrait gagner un facteur de 2 à 5 sur la résistivité, ce qui se traduit par un facteur de 1.5 à 3 sur le bruit en flux au niveau du SQUID, en utilisant un Cuivre de bonne qualité a 40 K, par rapport au refroidissement à l'Azote.

### Courant dans l'antenne primaire

Comme calculé précédemment, le bruit en courant dans l'antenne primaire est de l'ordre de

$$I_n = \simeq 1,25 \ \mathrm{pA}/\sqrt{\mathrm{Hz}} \qquad (7)$$

Il reste à savoir si ce bruit est suffisamment faible pour détecter le signal magnétique RMN sans moyennage dans le bruit. Pour calculer le courant dans l'antenne, on met en œuvre le calcul de Hoult et al., 1976 [21]. Par principe de réciprocité, la force électromotrice $E$ induite dans une antenne de forme arbitraire $C$ par un échantillon de magnétisation $M_0$ en rotation dans le plan xy est donnée par

$$\mathcal{E} = \int_{\mathrm{échantillon}} \frac{\partial}{\partial t} \vec{B_1}.\vec{M_0} dV \qquad (8)$$

où $B1$ est le champ induit par l'antenne C lorsqu'un courant unitaire parcourt l'antenne. Si $B_1$ est homogène sur le volume de l'échantillon, l'intégrale se calcule simplement :

$$\mathcal{E} = K\omega_0 B_1^{xy} M_0 V_s \cos(\omega_0 t) \qquad (9)$$

$K$ est une constante tenant compte des inhomogénéités de champ, $B^{xy}$ est la composante de $B_1$ orthogonale au champ de polarisation $B_0$. Pour une expérience d'IRM du genou, on prend pour volume d'intérêt une sphère de rayon 4 cm, soit $V_s = 2{,}68.10^{-4}$ $m^3$. La magnétisation $M_0$, dans le cadre de l'expérience de RMN biologique, est donnée par

$$M_0 = n\gamma^2 \hbar^2 I(I+1)\frac{B_0}{3k_B T} \qquad (10)$$

où $n$ est le nombre de spins par unité de volume, $I$ est le nombre quantique associé à la valeur propre de l'opérateur quantique $J^2$. D'après l'équation 9, on peut en déduire l'intensité du courant parcourant l'antenne, donnée par $i = E/Z,$ ou $Z(\omega)$ est l'impédance de l'antenne, qui est simplement

$$Z(\omega) = \sqrt{R^2 + L^2\omega^2} \simeq L\omega \qquad (11)$$

$L$ étant l'inductance totale du système (bobine d'entrée - antenne primaire).

Puis, en suivant la trame de Wenfeng Wu et al. [22], on détermine le champ $B_1$ par une bobine de type selle de cheval. Dans le cas présent, les paramètres à considérer sont $\Phi = 2\pi/3$ pour l'ouverture de la bobine, $R = 12,0$ (resp. 12,7) cm, $h = 36$ (resp. 38,1) cm pour l'antenne interne (resp. externe).

Le champ produit par cette bobine est par construction perpendiculaire à B0. On obtient donc, pour un courant unitaire

$$B_1^{xy} = \frac{2\mu_0 N}{\pi R} \sqrt{s-1}(s^{-1/2} + s^{3/2})\sin(\Phi/2) \qquad (12)$$

On considère d'abord simplement le cas de la bobine interne, avec $N = 1$ tour. $s = 1 + (h/D)^2$ est une fonction de la constante de structure de l'antenne. Dans le cas présent, s ≈ 3, 25. On obtient donc, avec les paramètres précités :

$$B_1^{xy,\text{int}} = 55,5\,\mu T \qquad (13)$$

pour l'antenne interne. Dans le cas de l'antenne externe, on obtient

$$B_1^{xy,\text{ext}} = 52,5\,\mu T \qquad (14)$$

Soit un champ équivalent vu par le gradiomètre $B_{1xy} = 3, 0\,\mu$T. La magnétisation de l'échantillon, elle, est donnée par

$$M_0 = 3,17.10^{-6}\ \text{A.m}^2 \qquad (15)$$

avec la valeur de $n$ pour l'eau, $n = 6, 6.10^{28}$ m$^{-3}$. La valeur de la force électromotrice est alors

$$\mathcal{E} = 6,8.10^{-10}\ \text{V} \qquad (16)$$

En tenant compte d'une résolution en fréquence de 1 Hz, on peut comparer ce résultat au bruit typique $V_n = 1$, 8.10$^{-12}$ V/ $Hz$. On trouve un ratio signal-à-bruit de 380, ce qui est largement suffisant pour de l'IRM clinique en des temps inférieurs à 10 min. Il faut toutefois prendre en compte les autres sources de bruit, provenant notamment de la chaîne de lecture (amplificateurs, convertisseurs analogique-numérique) ainsi que les sources de bruit externes, qui viendront fatalement dégrader le ratio signal-à-bruit.

Ce système de détection selon l'invention trouve son utilité dans plusieurs applications :

**L'imagerie par résonance magnétique (IRM)**

En effet, les expériences d'IRM très bas champ (en dessous de 10 mT) requièrent l'utilisation de détecteurs très sensibles pour pallier au manque de signal. La plupart des expériences d'IRM à SQUID existantes utilisent des antennes primaires de type surfacique, le plus souvent gradiométriques axiales d'ordre deux, comme divulgué par [23]. L'utilisation d'une antenne volumique permet de capturer plus de signal et donc d'augmenter le ratio signal à bruit du dispositif, et donc in fine la qualité d'image. Le caractère gradiométrique de l'antenne permet de se prémunir du bruit électromagnétique environnant, augmentant également le ratio signal à bruit.

**Le biomagnétisme.**

L'antenne primaire selon l'invention peut être utilisée pour détecter des signaux de RMN, de relaxométrie magnétique, de superparamagnétisme, ou trouver une utilité dans les immuno-essais magnétiques où la sensibilité du dispositif de détection est un facteur crucial. L'antenne selon l'invention peut également être utilisée pour des expériences de magnétoencéphalographie et de magnétocardiographie.

D'autres applications de la présente invention peuvent viser à mesurer des faibles variations de champ magnétique, notamment dans le cadre de la détection de submersibles, ou d'autres applications du domaine de la Défense, en particulier en guerre électronique. On peut également prévoir une utilisation en résonance magnétique nucléaire (RMN) dans l'agroalimentaire, notamment pour le contrôle qualité.

Bien sûr, la présente invention n'est pas limitée aux exemples de réalisation qui viennent d'être décrits et bien d'autres modes d'implémentation peuvent être envisagés sans sortir du cadre de l'invention défini par les revendications ci-jointes.

**Revendications**

1. Dispositif concentrateur de flux (5) disposé en amont d'un magnétomètre ultrasensible (3), prévu pour recevoir en entrée un flux magnétique externe et délivrer un flux concentré en entrée dudit magnétomètre (3), **caractérisé en ce qu'**il comprend une antenne primaire de détection magnétique volumique gradiométrique (50,60,70) refroidie à une température cryogénique et un transformateur de flux (55) disposé entre l'antenne primaire de détection (50,60,70) et le magnétomètre (3), ledit transformateur de flux (55) ayant un enroulement primaire (6) relié à ladite antenne primaire de détection (50,60,70).

2. Dispositif concentrateur selon la revendication précédente, **caractérisé en ce que** l'antenne primaire (60) comprend deux antennes en série respectivement interne et externe (63,65), présentant une même inductance et agencées de sorte que le courant parcourant l'antenne externe (65) est de sens opposé à celui parcourant l'antenne interne (63).

3. Dispositif concentrateur selon la revendication 1, **caractérisé en ce que** l'antenne primaire (60) comprend deux antennes en série respectivement interne et externe (63,65), présentant une même surface totale orientée et agencées de sorte que le courant parcourant l'antenne externe (65) est de sens opposé à celui parcourant l'antenne interne (63).

4. Dispositif concentrateur selon la revendication précédente, **caractérisé en ce que** l'antenne interne (63) est disposée à l'intérieur de l'antenne externe (65) et présente une longueur et un diamètre respectivement inférieurs à la longueur et à au diamètre respectifs de l'antenne externe.

5. Dispositif concentrateur selon la revendication précédente, **caractérisé en ce que** les antennes respectivement interne et externe (63,65) sont réalisées à partir de fils conducteurs respectivement interne et externe, le fil conducteur interne présentant une section inférieure à la section du fil conducteur externe.

6. Dispositif concentrateur l'une quelconque des revendications 2 à 4, **caractérisé en ce que** l'antenne primaire de détection (70) comprend en outre au moins une antenne intermédiaire (75) disposée en série entre l'antenne externe (77) et l'antenne interne (73).

7. Dispositif concentrateur selon l'une quelconque des revendications précédentes, **caractérisé en ce qu'**il comprend en outre des moyens pour blinder électromagnétiquement l'antenne primaire de détection.

8. Dispositif concentrateur selon la revendication précédente, **caractérisé en ce que** les moyens de blindage électromagnétique sont de type passif.

9. Dispositif concentrateur selon la revendication 7, **caractérisé en ce que** les moyens de blindage électromagnétique sont de type actif et mettent en œuvre au moins une bobine de compensation de bruit extérieur.

10. Dispositif concentrateur selon l'une quelconque des revendications précédentes, **caractérisé en ce qu'**il comprend en outre des moyens pour refroidir l'antenne primaire de détection par circulation d'un liquide cryogénique tel que de l'azote liquide.

11. Dispositif concentrateur selon l'une quelconque des revendications 1 à 8, **caractérisé en ce que** l'antenne primaire de détection est disposée dans un cryostat comportant un tube pulsé et un circuit d'hélium gazeux.

12. Equipement de résonance magnétique nucléaire dont le système de détection intègre un dispositif concentrateur de flux selon l'une quelconque des revendications précédentes.

13. Equipement d'imagerie par résonance magnétique dont le système de détection intègre un dispositif concentrateur de flux selon l'une quelconque des revendications 1 à 11.

14. Equipement de détection magnétique mis en œuvre dans des applications de biomagnétisme, dont le système de détection intègre un dispositif concentrateur de flux selon l'une quelconque des revendications 1 à 11.

15. Equipement pour mesurer des variations très faibles de champ magnétique statique, dont le système de détection intègre un dispositif concentrateur de flux selon l'une quelconque des revendications 1 à 11.

16. Equipement de détection magnétique large bande, dont le système de détection intègre un dispositif concentrateur de flux selon l'une quelconque des revendications 1 à 11.

17. Equipement de détection magnétique utilisé pour le contrôle qualité dans l'industrie agroalimentaire, dont le système de détection intègre un dispositif concentrateur de flux selon l'une quelconque des revendications 1 à 11.

18. Equipement de résonance magnétique nucléaire utilisé pour le contrôle qualité dans l'industrie agroalimentaire, dont le système de détection intègre un dispositif concentrateur de flux selon l'une quelconque des revendications 1 à 11.

19. Système (1) de détection et d'acquisition radiofréquence (RF) à base de SQUID, prévu notamment pour être intégré dans un appareil à résonance magnétique nucléaire (IRM ou RMN), comprenant:

    • un dispositif concentrateur de flux (5) selon l'une quelconque des revendications 1 à 11,
    • un dispositif SQUID (3), agencé pour être soumis au flux issu dudit dispositif concentrateur de flux (5), et délivrer un signal de détection secondaire,
    • un dispositif de cryogénie (56) prévu pour refroidir le dispositif SQUID (3),
    • un étage (4) de traitement du signal de détection secondaire émis par le dispositif SQUID (3), pour délivrer un signal analogique d'acquisition, comprenant une boucle à verrouillage de flux (FLL) prévue pour linéariser la réponse du dispositif SQUID (3).

20. Système (1) selon la revendication précédente, **caractérisé en ce que** le dispositif concentrateur de flux (5) comporte une zone prévue à l'intérieur de l'antenne de détection primaire (50) pour recevoir une partie (2) du corps d'un sujet humain ou animal.

## Patentansprüche

1. Flusskonzentratorvorrichtung (5), die von einem hochempfindlichen Magnetometer (3) stromaufwärts eingerichtet ist und zum Aufnehmen eines externen magnetischen Flusses als Eingang und Abgeben eines konzentrierten Flusses am Eingang des Magnetometers (3) vorgesehen ist,
**dadurch gekennzeichnet, dass** sie eine primäre gradiometrische Magnetvolumendetektionsantenne (50,60,70), die auf eine kryogene Temperatur abgekühlt ist, und einen Flusstransformator (55), der zwischen der primären Detektionsantenne (50,60,70) und dem Magnetometer (3) eingerichtet ist, umfasst, wobei der Flusstransformator (55) eine Primärwicklung (6) besitzt, die mit der primären Detektionsantenne (50,60,70) verbunden ist.

2. Konzentratorvorrichtung nach dem vorstehenden Anspruch,
**dadurch gekennzeichnet, dass** die primäre Antenne (60) zwei serielle Antennen, jeweils eine interne und eine externe (63,65), umfasst, die eine gleiche Induktivität aufweisen und angeordnet sind, sodass der Strom, der durch die externe Antenne (65) fließt, in entgegengesetzter Richtung zu dem ist, der durch die interne Antennen (63) fließt.

3. Konzentratorvorrichtung nach Anspruch 1
**dadurch gekennzeichnet, dass** die primäre Antenne (60) zwei serielle Antennen, jeweils eine interne und eine externe (63,65), umfasst, die die gleiche Gesamtoberfläche aufweisen, die ausgerichtet und angeordnet ist, sodass der Strom, der durch die externe Antenne (65) fließt, in entgegengesetzter Richtung zu dem ist, der durch die interne Antennen (63) fließt.

4. Konzentratorvorrichtung nach dem vorstehenden Anspruch,
**dadurch gekennzeichnet, dass** die interne Antenne (63) im Inneren der externen Antenne (65) eingerichtet ist und eine Länge und einen Durchmesser aufweist, die jeweils kleiner als die jeweilige Länge und der jeweilige Durchmesser der externen Antenne sind.

5. Konzentratorvorrichtung nach dem vorstehenden Anspruch,
**dadurch gekennzeichnet, dass** jeweils die interne und die externe Antenne (63,65) anhand von jeweils einem internen und einem externen Leitungsdraht realisiert werden, wobei der interne Leitungsdraht einen Abschnitt aufweist, der kleiner als der Abschnitt des externen Leitungsdrahts ist.

6. Konzentratorvorrichtung nach einem der Ansprüche 2 bis 4,
**dadurch gekennzeichnet, dass** die primäre Detektionsantenne (70) ferner mindestens eine Zwischenantenne (75) umfasst, die zwischen der externen Antenne (77) und der internen Antenne (73) seriell eingerichtet ist.

7. Konzentratorvorrichtung nach einem der vorstehenden Ansprüche, **dadurch gekennzeichnet, dass** sie ferner Mittel zum elektromagnetischen Abschirmen der primären Detektionsantenne umfasst.

8. Konzentratorvorrichtung nach dem vorstehenden Anspruch,
**dadurch gekennzeichnet, dass** die elektromagnetischen Abschirmmittel von passiver Art sind.

9. Konzentratorvorrichtung nach Anspruch 7,
**dadurch gekennzeichnet, dass** die elektromagnetischen Abschirmmittel von aktiver Art sind und mindestens eine Kompensationsspule für externes Rauschen operativ einsetzen.

10. Konzentratorvorrichtung nach einem der vorstehenden Ansprüche, **dadurch gekennzeichnet, dass** es ferner Mittel zum Abkühlen der primären Detektionsantenne durch Zirkulation einer kryogenen Flüssigkeit wie flüssigem Stickstoff umfasst.

11. Konzentratorvorrichtung nach einem der Ansprüche 1 bis 8,
**dadurch gekennzeichnet, dass** die primäre Detektionsantenne in einem Kryostat mit einer Impulsröhre und einem Kreislauf mit gasförmigen Helium eingerichtet ist.

12. Kernspinresonanzeinrichtung, wobei das Detektionssystem eine Flusskonzentratorvorrichtung nach einem der vorstehenden Ansprüche integriert.

13. Magnetresonanzbildgebungseinrichtung, wobei das Detektionssystem eine Flusskonzentratorvorrichtung nach einem der Ansprüche 1 bis 11 integriert.

14. Magnetdetektionseinrichtung, die in biomagnetischen Anwendungen eingesetzt werden, wobei das Detektionssystem eine Flusskonzentratorvorrichtung nach einem der Ansprüche 1 bis 11 integriert.

15. Vorrichtung zum Messen kleinster Variationen eines statischen Magnetfelds, wobei das Detektionssystem eine Flusskonzentratorvorrichtung nach einem der Ansprüche 1 bis 11 integriert.

16. Breitband-Magnetdetektionseinrichtung, wobei das Detektionssystem eine Flusskonzentratorvorrichtung nach einem der Ansprüche 1 bis 11 integriert.

17. Magnetdetektionseinrichtung, die für die Qualitätskontrolle in der Lebensmittelindustrie verwendet wird, wobei das Detektionssystem eine Flusskonzentratorvorrichtung nach einem der Ansprüche 1 bis 11 integriert.

18. Kernspinresonanzeinrichtung für die Qualitätskontrolle in der Lebensmittelindustrie, wobei das Detektionssystem eine Flusskonzentratorvorrichtung nach einem der Ansprüche 1 bis 11 integriert.

19. SQUID-basiertes Hochfrequenz-Detektions- und Erfassungssystem (HF-Detektions- und Erfassungssystem) (1), das insbesondere dazu vorgesehen ist, in ein Kernspinresonanzgerät (IRM oder RMN) integriert zu sein, umfassend:

   • eine Flusskonzentratorvorrichtung (5) nach einem der Ansprüche 1 bis 11,
   • eine SQUID-Vorrichtung (3), die angeordnet ist, um dem Fluss der Flusskonzentratorvorrichtung (5) ausgesetzt zu werden und ein sekundäres Detektionssignal zu liefern,
   • eine Kryogenikvorrichtung (56), die zum Abkühlen der SQUID-Vorrichtung (3) vorgesehen ist,
   • eine Stufe (4) für die Verarbeitung des sekundären Detektionssignals, das durch die SQUID-Vorrichtung (3) emittiert wird, zum Liefern eines analogen Erfassungssignals, umfassend eine Flussregelschleife (FLL), die zum Linearisieren der Reaktion der SQUID-Vorrichtung (3) vorgesehen ist.

20. System (1) nach dem vorstehenden Anspruch,
**dadurch gekennzeichnet, dass** die Flusskonzentratorvorrichtung (5) einen Bereich im Inneren der primären Detektionsantenne (50) vorweist, zum Aufnehmen eines Teils (2) des Körpers eines menschlichen oder tierischen Subjekts.

**Claims**

1. Flux concentrator device (5) arranged upstream of an ultrasensitive magnetometer (3), which device is provided to receive an external magnetic flux as input and to deliver a concentrated flux as input to said magnetometer (3), **characterized in that** the device comprises a primary gradiometric volumetric magnetic detection antenna (50,60,70), cooled to a cryogenic temperature, and a flux transformer (55) arranged between the primary detection antenna (50,60,70) and the magnetometer (3), said flux transformer (55) having a primary winding (6) connected to said primary detection antenna (50,60,70).

2. Concentrator device according to the preceding claim, **characterized in that** the primary antenna (60) comprises two antennas (63,65), namely an internal and external antenna, in series, having the same inductance and arranged so that the current flowing through the external antenna (65) is in the opposite direction to that flowing through the internal antenna (63).

3. Concentrator device according to claim 1, **characterized in that** the primary antenna (60) comprises two antennas (63,65), namely an internal and external antenna, in series, having the same total oriented surface and arranged so that the current flowing through the external antenna (65) is in the opposite direction to that flowing through the internal antenna (63).

4. Concentrator device according to the preceding claim,
   **characterized in that** the internal antenna (63) is arranged inside the external antenna (65) and has a length and diameter less than the length and diameter, respectively, of the external antenna.

5. Concentrator device according to the preceding claim, **characterized in that** the internal and external antennas (63,65) are made from conducting wires, namely internal and external conducting wires, the internal conducting wire having a cross-section smaller than the cross-section of the external conducting wire.

6. Concentrator device according to any of claims 2 to 4, **characterized in that** the primary detection antenna (70) further comprises at least one intermediate antenna (75) arranged in series between the external antenna (77) and the internal antenna (73).

7. Concentrator device according to any of the preceding claims,
   **characterized in that** it further comprises means for electromagnetically shielding the primary detection antenna.

8. Concentrator device according to the preceding claim, **characterized in that** the electromagnetic shielding means are passive.

9. Concentrator device according to claim 7, **characterized in that** the electromagnetic shielding means are active and implement at least one external noise compensation coil.

10. Concentrator device according to any of the preceding claims,
    **characterized in that** it further comprises means for cooling the primary detection antenna by circulating a cryogenic liquid such as liquid nitrogen.

11. Concentrator device according to any of claims 1 to 8,
    **characterized in that** the primary detection antenna is arranged in a cryostat comprising a pulse tube and a gaseous helium circuit.

12. Nuclear magnetic resonance equipment, the detection system of which incorporates a flux concentrator device according to any of the preceding claims.

13. Magnetic resonance imaging equipment, the detection system of which incorporates a flux concentrator device according to any of claims 1 to 11.

14. Magnetic detection equipment implemented in biomagnetism applications, the detection system of which incorporates a flux concentrator device according to any of claims 1 to 11.

15. Equipment for measuring very small variations in a static magnetic field, the detection system of which incorporates a flux concentrator device according to any of claims 1 to 11.

16. Broadband magnetic detection equipment, the detection system of which incorporates a flux concentrator device according to any of claims 1 to 11.

17. Magnetic detection equipment used for quality control in the agri-food industry, the detection system of which incorporates a flux concentrator device according to any of claims 1 to 11.

18. Nuclear magnetic resonance equipment used for quality control in the agri-food industry, the detection system of which incorporates a flux concentrator device according to any of claims 1 to 11.

19. System (1) for radio frequency (RF) detection and acquisition based on SQUID, provided in particular to be integrated into a nuclear magnetic resonance (MRI or NMR) apparatus, comprising:

   • a flux concentrator device (5) according to any of claims 1 to 11,
   • a SQUID device (3), arranged to be subjected to the flux from said flux concentrator device (5), and to deliver a secondary detection signal,
   • a cryogenic device (56) provided to cool the SQUID device (3),
   • a stage (4) for processing the secondary detection signal emitted by the SQUID device (3) to deliver an analog acquisition signal, comprising a flux-locked loop (FLL) provided to linearize the response of the SQUID device (3).

20. System (1) according to the preceding claim, **characterized in that** the flux concentrator device (5) comprises a zone provided within the primary detection antenna (50) to receive a part (2) of the body of a human or animal subject.

[Fig. 1]

[Fig. 2]

[Fig. 3]

## RÉFÉRENCES CITÉES DANS LA DESCRIPTION

**Documents brevets cités dans la description**

- JP 2010148578 A
- US 2013271142 A1
- WO 2006052236 A1
- DE 19509230 A1
- CN 106814338
- CN 107430174 A
- WO 2009023303 A2, Penanen
- FR 2012642

**Littérature non-brevet citée dans la description**

- **STOLZ et al.** *Supercond. Sci. Technol.*, 1999, vol. 12, 806-808
- **D. DRUNG et al.** dc SQUID readout electronics with up to 100 MHz clo8ed-loop bandwidth. *IEEE Tran8action8 on Applied Superconductivity*, June 2005, vol. 15 (2), 777-780
- **J. CLARKE ; A.I. BRAGIN8KI**. The SQUID handbook. Wiley-VCH, vol. 1
- **FAGALY et al.** *Review of Scientific Instruments*, 2006, vol. 77, 101101
- SQUID sensors : Fundamentals, Fabrication and Applications. NATO ASI Series. Springer Science, 1995, 117-178
- **SETON et al.** *Magnetic resonance materials in physics, biology and medicine*, 1999, vol. 8, 116-120
- **STOLZ**. *IEEE Transactions on applied superconductivity 11*, 2001, vol. 1
- **TAVRIN et al.** *Supercond. Sci. Technol.*, 1994, vol. 7, 265-268
- **OISJOEN et al.** *Supercond. Sci. Technol*, 2008, vol. 21, 034004
- **SCHMIDT et al.** *Exploration Geophysics*, 2004, vol. 35, 297-305
- **SCHULTZE et al.** *Supercond. Sci. Technol*, 2002, vol. 15, 120-125
- **NARDELLI et al.** *EPJ Quantum Technology*, 2020, vol. 7, 11
- **CHEN et al.** *Journal of applied physics*, 2011, vol. 110, 093903
- **HOUT et al.** *J. of Mag. Res. 24*, 1976, vol. 1, 71-85
- *AIP Advances*, 2018, vol. 8, 075126
- **S. CALATRONI**. *arXiv 2006.02842vl*